(19) Europäisches Patentamt
European Patent Office
Office européen des brevets

(11) **EP 3 446 387 B1**

(12) **EUROPÄISCHE PATENTSCHRIFT**

(45) Veröffentlichungstag und Bekanntmachung des Hinweises auf die Patenterteilung:
**31.05.2023 Patentblatt 2023/22**

(21) Anmeldenummer: **16726098.3**

(22) Anmeldetag: **31.05.2016**

(51) Internationale Patentklassifikation (IPC):
*H02H 1/00* (2006.01)     *H02H 3/38* (2006.01)
*H02H 3/44* (2006.01)     *H02H 3/50* (2006.01)

(52) Gemeinsame Patentklassifikation (CPC):
**H02H 1/0015; H02H 1/0023;** H02H 3/38;
H02H 3/44; H02H 3/50

(86) Internationale Anmeldenummer:
**PCT/EP2016/062272**

(87) Internationale Veröffentlichungsnummer:
**WO 2017/207030 (07.12.2017 Gazette 2017/49)**

(54) **STÖRLICHTBOGENERKENNUNGSEINHEIT**

FAULT-ARC IDENTIFICATION UNIT

UNITÉ DE DÉTECTION D'ARCS ÉLECTRIQUES PARASITES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**27.02.2019 Patentblatt 2019/09**

(73) Patentinhaber: **Siemens Aktiengesellschaft**
**80333 München (DE)**

(72) Erfinder:
• **WENZLAFF, Karsten**
**01097 Dresden (DE)**
• **MEYER, Jörg**
**01157 Dresden (DE)**
• **SCHEGNER, Peter**
**01259 Dresden (DE)**

(74) Vertreter: **Siemens Patent Attorneys**
**Postfach 22 16 34**
**80506 München (DE)**

(56) Entgegenhaltungen:
**EP-A2- 2 426 802     US-A1- 2011 019 444**
**US-B1- 6 987 389**

**Beschreibung**

Die Erfindung betrifft eine Störlichtbogenerkennungseinheit, einen Leistungsschalter, einen Kurzschließer und ein Verfahren zur Störlichtbogenerkennung.

In Niederspannungsstromkreisen bzw. Niederspannungsanlagen respektive Niederspannungsnetzen, d.h. Stromkreise für Spannungen bis 1000 Volt Wechselspannung oder 1500 Volt Gleichspannung, sind Kurzschlüsse meist mit auftretenden Störlichtbögen, wie parallele oder serielle Störlichtbögen, verbunden. Besonders in leistungsstarken Verteil- und Schaltanlagen können diese bei einer nicht ausreichend schnellen Abschaltung zu verheerenden Zerstörungen von Betriebsmitteln, Anlagenteilen oder kompletten Schaltanlagen führen. Um einen länger andauernden und großflächigen Ausfall der Energieversorgung zu vermeiden und Personenschäden zu reduzieren, ist es erforderlich derartige Störlichtbögen, insbesondere stromstarke bzw. parallele Störlichtbögen, in wenigen Millisekunden zu erkennen und zu löschen. Konventionelle Schutzsysteme von Energieversorgungsanlagen (z.B. Sicherungen und Leistungsschalter) können unter den geforderten zeitlichen Anforderungen keinen zuverlässigen Schutz bieten.

Mit Leistungsschalter sind hier insbesondere Schalter für Niederspannung gemeint. Leistungsschalter werden, insbesondere in Niederspannungsanlagen, üblicherweise für Ströme von 63 bis 6300 Ampere eingesetzt. Spezieller werden geschlossene Leistungsschalter, wie Moulded Case Circuit Breaker, für Ströme von 63 bis 1600 Ampere, insbesondere von 125 bis 630 oder 1200 Ampere eingesetzt. Offene Leistungsschalter bzw. Luftleistungsschalter, wie Air Circuit Breaker, werden insbesondere für Ströme von 630 bis 6300 Ampere, spezieller von 1200 bis 6300 Ampere eingesetzt.

Leistungsschalter im Sinne der Erfindung können insbesondere eine elektronischen Auslöseeinheit, auch als Electronic Trip Unit, kurz ETU, bezeichnet, aufweisen.

Leistungsschalter überwachen den durch sie hindurchfließenden Strom und unterbrechen den elektrischen Strom bzw. Energiefluss zu einer Energiesenke bzw. einem Verbraucher, was als Auslösung bezeichnet wird, wenn Stromgrenzwerte oder Strom-Zeitspannengrenzwerte, d.h. wenn ein Stromwert für eine gewisse Zeitspanne vorliegt, überschritten werden. Die Ermittlung von Auslösebedingungen und das Auslösen eines Leistungsschalters kann mittels einer elektronischen Auslöseeinheit erfolgen.

Kurzschließer sind spezielle Einrichtungen zum Kurzschließen von Leitungen bzw. Stromschienen, um definierte Kurzschlüsse zum Schutz von Stromkreisen bzw. Anlagen herzustellen.

Konventionelle Störlichtbogendetektionssysteme werten die durch den Lichtbogen erzeugte Lichtemission aus und detektieren hiermit den Störlichtbogen.

Dies hat den Nachteil, dass parallel zu den elektrischen Leitungen bzw. Stromschienen Lichtwellenleiter bzw. optische Detektionssysteme verlegt werden müssen, um eventuell auftretende Störlichtbögen zu erkennen.

Die amerikanische Patentanmeldung US 2011/0019444 A1 offenbart ein Verfahren und eine Vorrichtung zum Verwalten von Gleichstromlichtbogenfehlern. Mindestens ein Teil des Verfahrens wird von einer Steuerung ausgeführt, die mindestens einen Prozessor umfasst. In einer Ausführungsform umfasst das Verfahren das Analysieren einer Signatur eines Signals eines Leistungswandlers und das Bestimmen, ob ein Lichtbogenfehler vorliegt, basierend auf der Analyse der Signatur

Das amerikanische Patent US 6,987,389 B1 offenbart eine Lichtbogenfehlerschutzvorrichtung. Diese schützt einen Zweigstromkreisabschnitt eines elektrischen Verteilungssystems. Der Abzweigkreis ist mit einer Last verbunden. Ein erster Sensor erfasst Schwankungen des Netzstroms, während ein zweiter Sensor Schwankungen der Netzspannung erfasst. Die Polaritäten der Schwankungen werden verglichen, und der Vergleich zeigt an, ob eine Lichtbogensignatur, die möglicherweise einen Lichtbogenfehler anzeigt, im Verzweigungsschaltungsabschnitt oder in einem Rest des elektrischen Verteilungssystems lokalisiert ist.

Die europäische Patentanmeldung EP 2 426 802 A2 offenbart eine Vorrichtung zum schnellen Bestimmen eines Fehlers in einem elektrischen Energiesystem, umfassend einen Stromwandler, eine Strombestimmungseinheit und eine Fehlerbestimmungseinheit. Der Stromwandler erfasst den dem Stromnetz zugeführten Strom und gibt eine Stromerfassungsspannung aus. Die Strombestimmungseinheit vergleicht jeweils die Stromerfassungsspannung, die Differenzspannung erster Ordnung der Stromerfassungsspannung und die Differenzspannung zweiter Ordnung der Stromerfassungsspannung mit vorbestimmten ersten, zweiten und dritten Referenzspannungen. Die Fehlerbestimmungseinheit bestimmt basierend auf dem Vergleichsergebnis der Strombestimmungseinheit, ob ein Fehler auftritt, und erzeugt ein Auslösesignal, wenn bestimmt wird, dass der Fehler aufgetreten ist.

Aufgabe der vorliegenden Erfindung ist es, eine Möglichkeit zur Störlichtbogenerkennung aufzuzeigen.

Diese Aufgabe wird durch eine Störlichtbogenerkennungseinheit mit den Merkmalen des Patentanspruchs 1, einen Leistungsschalter gemäß Patentanspruch 10, einen Kurzschließer gemäß Patentanspruch 11 und ein Verfahren mit den Merkmalen des Patentspruchs 12 gelöst.

Erfindungsgemäß ist vorgesehen, dass eine Störlichtbogenerkennungseinheit für einen elektrischen Niederspannungswechselstromkreis mindestens einen Spannungssensor, zur periodischen Ermittlung von elektrischen Spannungswerten (un, un-1) des elektrischen Stromkreises, mindestens einen Stromsensor, zur periodischen Ermittlung von Stromgrößen des elektrischen Stromkreises, die mit einer Auswerteeinheit verbunden sind aufweist. Diese sind derart ausgestaltet, dass als erstes Kriterium eine Änderung der Spannung nach der Zeit, die einen ersten Schwellwertes SW1 überschreitet oder einen zweiten Schwellwert SW2 unterschreitet erfüllt sein muss - wobei nur hinsichtlich eines der beiden Bedingungen geprüft werden muss, d.h. es könnte beispielsweise nur eine Überprüfung hinsichtlich einer Überschreitung erfolgen.

Als zweites Kriterium eine Differenz des Stromanstieges, der einen dritten Schwellwert SW3 überschreitet oder einen vierten Schwellwert SW4 unterschreitet, vorliegen muss - wobei nur hinsichtlich eines der beiden Bedingungen geprüft werden muss, d.h. es könnte beispielsweise nur eine Überprüfung hinsichtlich einer Unterschreitung erfolgen. Zusätzlich muss der Strom einen fünften Schwellwert SW5 überschreiten, um ein Störlichtbogenerkennungssignal abzugeben. D.h. es muss zusätzlich zum ersten und zweiten Kriterium ein weiteres Kriterium erfüllt sein, Überschreitung des fünften Schwellwertes SW5, ehe ein Störlichtbogenerkennungssignal abgegeben wird.

Dies hat den besonderen Vorteil, dass eine noch genauere Erkennung von Störlichtbögen ermöglicht wird, da diese häufig erst bei höheren Strömen auftreten. Somit können fehlerhafte Störlichtbogenerkennungssignale vermieden werden.

Allgemein gesagt wird hinsichtlich der Spannung die Änderung der Spannung nach der Zeit mit Schwellwerten verglichen und bei Überschreitung oder Unterschreitung eines Schwellwertes ist das erste Kriterium erfüllt.

Die Beträge des ersten und des zweiten Schwellwertes SW1, SW2 können dabei identisch sein, wobei sich lediglich das Vorzeichen unterscheidet.

Wesentlich ist, dass Spannungssprünge bzw. schnelle Änderungen der Spannung, die einen Schwellwert über- (z.B. bei positiven Spannungsänderungen) bzw. unterschreiten (z.B. bei negativen Spannungsänderungen bzw. der negativen Halbwelle), erkannt werden und zu einem Störlichtbogenerkennungssignal führen. Störlichtbogen weisen bei Zündung des Lichtbogens starke Spannungssprünge auf. Diese werden erfindungsgemäß detektiert und bilden ein Kriterium für die Abgabe eines Störlichtbogenerkennungssignals.

Hinsichtlich des Stromes wird die Differenz des Stromanstieges, d.h. die Differenz des Anstiegs oder Abfalls des Stromes nach der Zeit, ermittelt. Über-/unterschreitet die Differenz gewisse Schwellwerte, insbesondere bei einer Reduzierung des Stromanstieges, ist ein weiteres Kriterium für ein Störlichtbogenerkennungssignal erfüllt.

Bei vorzeichenbehafteten Änderungen des Stromanstieges, beispielsweise bei Wechselstrom, kann je nach ansteigender oder fallender Flanke des - idealerweise - sinusförmigen Wechselstroms und Art der Differenzberechnung eine Unterschreitung, beispielsweise bei einer Reduzierung des Stromanstieges bei ansteigender Flanke kann eine negative Differenz die Folge sein, wobei hinsichtlich der Unterschreitung eines (negativen) Schwellwertes geprüft wird; bzw. Überschreitung, beispielsweise bei fallenden Flanken des Wechselstroms (beim Sinus von 90° bis 270°) kann (abhängig von der Differenzberechnung) bei einer Reduzierung des Stromanstieges eine positive Differenz die Folge sein, die hinsichtlich eines Schwellwertes auf dessen Überschreitung geprüft wird.

Wesentlich ist, dass die Beträge der Differenz einen Schwellwert überschreiten, um ein Störlichtbogenerkennungssignal abzugeben. Es muss aber im einfachsten Fall keine betragsmäßige Überprüfung stattfinden, sondern es kann beispielsweise eine Überprüfung der (absoluten) Differenz hinsichtlich eines (absoluten) Schwellwertes erfolgen.

Wesentlich ist, dass Änderungen - insbesondere Reduzierungen - des Stromanstieges, die den üblichen Stromanstieg des Stromes im Stromkreis unterschreiten, erkannt werden und zu einem Störlichtbogenerkennungssignal führen. Mit üblichem Stromanstieg ist dabei beispielsweise der sinusförmige Stromanstieg des Wechselstromes in einem üblichen Stromkreis, beispielsweise Niederspannungsstromkreis, z.B. mit 230/400 Volt Nennspannung und 50 Hz Netzfrequenz, gemeint. Wobei beim genannten Niederspannungsstromkreis der Anstieg des idealerweise sinusförmigen Stromes gemeint ist. Störlichtbogen weisen bei Zündung des Lichtbogens Reduzierungen des Stromanstieges auf. Diese werden erfindungsgemäß detektiert und erfüllen ein Kriterium für ein Störlichtbogenerkennungssignal.

Erfindungsgemäß wird sowohl hinsichtlich Spannungssprüngen als auch Differenzen des Stromanstieges geprüft. Zusätzlich muss der Strom einen fünften Schwellwert SW5 überschreiten. Nur wenn alle drei Kriterien erfüllt sind, erfolgt die Abgabe eines Störlichtbogenerkennungssignals. Dies hat den besonderen Vorteil, dass eine besonders sichere Möglichkeit zur Störlichtbogenerkennung gegeben ist.

Vorteilhafte Ausgestaltungen der Erfindung sind in den Unteransprüchen angegeben.

In einer vorteilhaften Ausgestaltung der Erfindung ist die Auswerteeinheit derart ausgestaltet, dass fortlaufend aus zwei zeitlich aufeinanderfolgenden Spannungswerten (un, un-1) eine Spannungsdifferenz (dun) ermittelt wird. Die Spannungsdifferenz (dun) wird durch die zeitliche Differenz (dtn) der Spannungswerte (un, un-1) dividiert. Der somit ermittelte spannungsseitige erste Differenzenquotient (Dqun) wird, als Maß für die Änderung der Spannung nach der Zeit, mit dem ersten Schwellwert (SW1) verglichen. Bei dessen Überschreitung ist ein Kriterium für ein Störlichtbogenerkennungssignal erfüllt.

Dies hat den besonderen Vorteil, dass hinsichtlich positiver Änderungen der Spannung nach der Zeit, die den Schwellwert überschreiten, eine Störlichtbogenermittlung durchgeführt wird. D.h. positive Änderungen bzw. die positive Halbwelle der Spannung betreffende Änderungen werden erkannt. Somit steht eine einfache Ermittlungsmöglichkeit zur Verfügung.

**EP 3 446 387 B1**

In einer vorteilhaften Ausgestaltung der Erfindung ist die Auswerteeinheit derart ausgestaltet, dass fortlaufend aus zwei zeitlich aufeinanderfolgenden Spannungswerten (un, un-1) eine Spannungsdifferenz (dun) ermittelt wird. Die Spannungsdifferenz (dun) wird durch die zeitliche Differenz (dtn) der Spannungswerte (un, un-1) dividiert. Der daraus ermittelte erste Differenzenquotient (Dqun) wird, als Maß für die Änderung der Spannung nach der Zeit, mit dem zweiten Schwellwert (SW2) verglichen. Bei dessen Unterschreitung ist ein Kriterium für ein Störlichtbogenerkennungssignal erfüllt.

Dies hat den besonderen Vorteil, dass hinsichtlich negativer Änderungen der Spannung nach der Zeit, die den Schwellwert unterschreiten, eine Störlichtbogenermittlung durchgeführt wird. D.h. negative Änderungen bzw. die negative Halbwelle der Spannung betreffende Änderungen werden erkannt. Somit steht eine weitere einfache Ermittlungsmöglichkeit zur Verfügung.

In einer vorteilhaften Ausgestaltung der Erfindung ist die Auswerteeinheit derart ausgestaltet, dass fortlaufend aus zwei zeitlich aufeinanderfolgenden Spannungswerten (un, un-1) eine Spannungsdifferenz (dun) ermittelt wird. Die Spannungsdifferenz (dun) wird durch die zeitliche Differenz (dtn) der Spannungswerte (un, un-1) dividiert. Der Betrag des daraus ermittelten ersten Differenzenquotienten (Dqun) wird, als Maß für die Änderung der Spannung nach der Zeit, mit dem ersten Schwellwert (SW1) verglichen. Bei dessen Überschreitung ist ein Kriterium für ein Störlichtbogenerkennungssignal erfüllt. Dies hat den besonderen Vorteil, dass hinsichtlich sowohl positiver als auch negativer Änderungen der Spannung nach der Zeit eine Störlichtbogenermittlung durchgeführt wird, da der vorzeichenlose Betrag der Änderung der Spannung nach der Zeit ausgewertet wird. Überschreitet der Betrag den ersten Schwellwert, ist ein Kriterium für ein Störlichtbogenerkennungssignal erfüllt. Somit steht eine Ermittlungsmöglichkeit für sowohl positive als auch negative Spannungsänderungen bzw. -Sprünge zur Verfügung.

Zusätzlich zum fünften Schwellwert kann auch ein weiteres Kriterium erfüllt sein, beispielsweise das Vorliegen einer akustischen oder/und optischen Störlichtbogensignals. Dieses kann in analoger Weise mit dem bisherigen verknüpft werden. Damit ist eine genauere Erkennung eines Störlichtbogens auf Grund eines weiteren Kriteriums möglich, Somit werden fehlerhafte Störlichtbogensignale vermieden.

In einer vorteilhaften Ausgestaltung der Erfindung wird als elektrische Stromgröße entweder ein elektrischer Stromwert (in) oder/und ein Wert für die Änderung des elektrischen Stromes nach der Zeit (i'n) respektive Differenzenquotient (dqin) ermittelt. So kann beispielsweise der Stromwert durch einen üblichen Stromsensor ermittelt werden. Die Änderung des elektrischen Stromes nach der Zeit kann beispielsweise durch eine Rogowskispule erfolgen.

Dies hat den Vorteil, dass für die Erfindung sowohl übliche Stromsensoren als auch Stromänderungssensoren verwendet werden können. Insbesondere bei Verwendung von Sensoren, die die Änderung des elektrischen Stromes nach der Zeit ermitteln, ist eine einfache Ermittlung der Differenz des Stromanstieges möglich.

In einer vorteilhaften Ausgestaltung der Erfindung ist die Auswerteeinheit derart ausgestaltet, dass im Falle der Ermittlung von Stromwerten fortlaufend aus zwei zeitlich aufeinanderfolgenden Stromwerten (in, in-1) eine Stromdifferenz (din) ermittelt wird, die Stromdifferenz (din) durch die zeitliche Differenz (dtn) der Stromwerte dividiert wird, um so einen Differenzenquotienten (dqin) als Wert für die Änderung des elektrischen Stromes nach der Zeit zu ermitteln. Dies hat den besonderen Vorteil, dass eine besonders einfache Möglichkeit zur Ermittlung der Änderung des elektrischen Stromes nach der Zeit gegeben ist.

In einer vorteilhaften Ausgestaltung der Erfindung ist die Auswerteeinheit derart ausgestaltet, dass der ermittelte bzw. gemessene stromseitige zweite Differenzenquotient (dqin) vom vorhergehenden Differenzenquotienten (dqin-1) subtrahiert wird. Im Falle einer ersten Berechnung hat der vorhergehende Differenzenquotient den Wert Null. Die daraus ermittelte Differenz (Ddqin) wird, als Maß für die Änderung des Stromanstieges, mit dem dritten Schwellwert SW3 verglichen. Bei dessen Überschreitung ist ein Kriterium für ein Störlichtbogenerkennungssignal erfüllt.

Dies hat den besonderen Vorteil, dass bei einer fallenden Flanke im Stromverlauf die Änderungen des Stromes mit einer signifikanten Reduzierung des Stromanstieges zur Erkennung eines Störlichtbogens ermöglicht. Somit steht eine einfache Ermittlungsmöglichkeit zur Verfügung.

In einer vorteilhaften Ausgestaltung der Erfindung ist die Auswerteeinheit derart ausgestaltet, dass der ermittelte bzw. gemessene zweite Differenzenquotient (dqin) vom vorhergehenden Differenzenquotienten (dqin-1) subtrahiert wird. Die daraus ermittelte Differenz (Ddqin) des Differenzenquotienten wird, als Maß für die Änderung des Stromanstieges, mit dem vierten Schwellwert SW4 verglichen. Bei dessen Unterschreitung ist ein Kriterium für ein Störlichtbogenerkennungssignal erfüllt.

Dies hat den besonderen Vorteil, dass hinsichtlich einer steigenden Flanke des Stromes mit einer Reduzierung des Stromanstiegs eine Erkennung eines Störlichtbogens möglich ist. Somit steht eine weitere einfache Ermittlungsmöglichkeit zur Verfügung.

In einer vorteilhaften Ausgestaltung der Erfindung ist die Auswerteeinheit derart ausgestaltet, dass der ermittelte bzw. gemessene zweite Differenzenquotient (dqin) wird vom vorhergehenden Differenzenquotienten (dqin-1) subtrahiert. Der Betrag der daraus ermittelten Differenz (Ddqin) des Differenzenquotienten wird, als Maß für die Änderung des Stromanstieges, mit dem dritten Schwellwert SW3 verglichen. Bei dessen Überschreitung ist ein Kriterium für ein Störlichtbogenerkennungssignal erfüllt.

4

EP 3 446 387 B1

Dies hat den besonderen Vorteil, dass sowohl hinsichtlich fallender als auch ansteigender Flanken des Stromes mit Reduzierungen des Stromanstieges eine Erkennung eines Störlichtbogens möglich ist. Somit steht eine Ermittlungsmöglichkeit für sowohl fallende als auch steigende Flanken bei Stromänderungen, insbesondere für Wechselstrom, zur Verfügung.

Erfindungsgemäß ist ferner ein Leistungsschalter für einen elektrischen Niederspannungsstromkreis vorgesehen. Dieser weist eine erfindungsgemäße Störlichtbogenerkennungseinheit auf. Diese ist mit dem Leistungsschalter verbunden, wobei diese derart ausgestaltet sind, dass bei Abgabe eines Störlichtbogenerkennungssignals der Leistungsschalter auslöst, d.h. den elektrischen Stromkreis unterbricht. Somit kann eine Löschung des Störlichtbogens erreicht werden. Weist der Leistungsschalter eine elektronische Auslöseeinheit auf, kann eine sehr schnelle Auslösung des Leistungsschalters bei Vorliegen eines Störlichtbogenerkennungssignals erreicht werden. Dies hat den besonderen Vorteil, dass ein Leistungsschalter um eine weitere, vorteilhafte Funktionalität zum Schutz elektrischer Anlagen erweitert wird. Die Erkennung und Abschaltung von Störlichtbögen erfolgt dabei vorteilhaft in einem Gerät. Gegebenenfalls lassen sich vorhandene Baugruppen, wie Spannungs- oder/und Stromsensoren, Netzteil, Mikroprozessoren für die Auswerteeinheit, etc. mitverwenden und so Synergien erzielen.

Erfindungsgemäß ist ferner ein Kurzschließer, aufweisend eine Störlichtbogenerkennungseinheit, die mit dem Kurzschließer verbunden ist, vorgesehen. Diese sind derart ausgestaltet, dass bei Abgabe eines Störlichtbogenerkennungssignals der Kurzschließer den elektrischen Stromkreis kurzschließt, um ein Löschen des Störlichtbogens zu bewirken.

Dies hat den besonderen Vorteil, dass eine einfache, schnelle und wirksame Möglichkeit zum Löschen von Störlichtbögen zur Verfügung steht.

Erfindungsgemäß ist des Weiteren ein Verfahren zur Störlichtbogenerkennung für einen elektrischen Wechselstromkreis vorgesehen.

Hierbei werden periodisch elektrische Spannungs- (un, un-1) und elektrische Stromerte (in, in-1) des Stromkreises ermittelt und nur dann ein Störlichtbogenerkennungssignal abgegeben wird, wenn mindestens folgende drei Kriterien erfüllt sind: Bei Überschreitung eines ersten Schwellwertes (SW1), alternativ oder parallel bei Unterschreitung eines zweiten Schwellwertes (SW2), der Änderung der Spannung nach der Zeit ist ein erstes Kriterium erfüllt. Bei einer Änderung des Stromanstieges, der einen dritten Schwellwert (SW3) überschreitet, alternativ oder parallel einen vierten Schwellwert (SW4) unterschreitet, ist ein zweites Kriterium erfüllt.

Das dritte Kriterium besteht in der Überschreitung eines fünften Schwellwert (SW5) des Stromwertes.

Dies hat den besonderen Vorteil eines einfachen Verfahrens zur Störlichtbogenerkennung.

Alle Ausgestaltungen und Merkmale der Erfindung bewirken eine Verbesserung der Erkennung von Störlichtbögen bzw. deren Löschung.

Die beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Hierbei zeigt:

Figur 1 ein Diagramm des zeitlichen Spannungs- und Stromverlaufes nach Lichtbogenzündung

Figur 2 ein Ablaufdiagramm zur Störlichtbogenerkennung

Figur 3 ein Blockschaltbild einer erfindungsgemäßen Lösung

Figur 4 eine erste Darstellung zur Erläuterung des Einsatzes der Erfindung

Figur 5 eine zweite Darstellung zur Erläuterung des Einsatzes der Erfindung

Figur 6 eine dritte Darstellung zur Erläuterung des Einsatzes der Erfindung

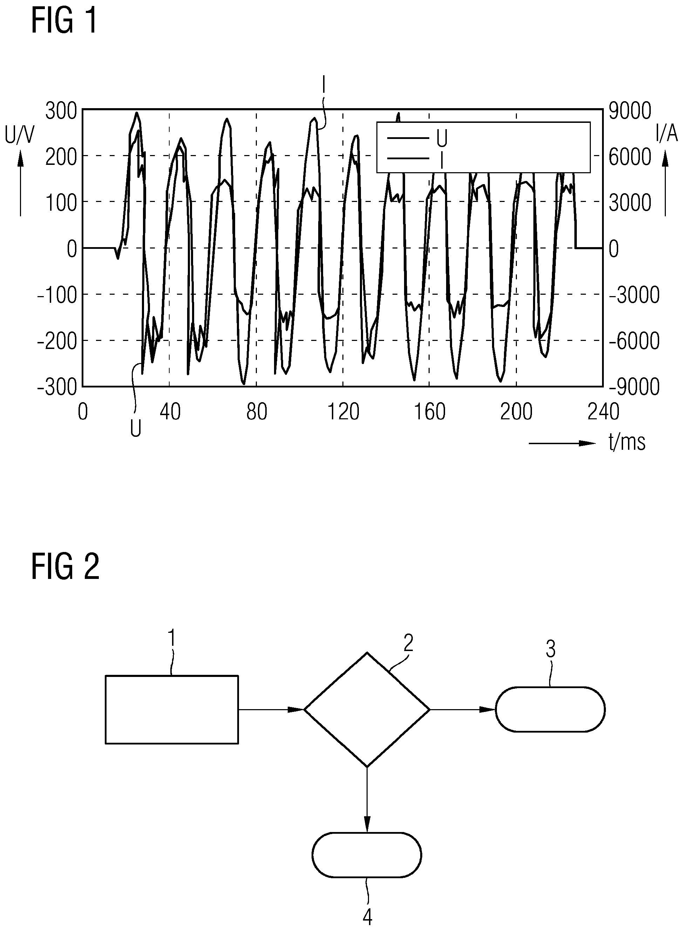

In einem Stromkreis bzw. Netz, in dem ein Störlichtbogen brennt, kann ein Strom- und Spannungsverlauf gemessen werden, der einen signifikanten Verlauf aufweist. Ein typischer Spannungs- und Stromverlauf für einen Störlichtbogen ist in Figur 1 dargestellt. Figur 1 zeigt eine Darstellung eines Diagramms, in dem der zeitliche Verlauf der elektrischen Spannung U und des elektrischen Stromes I nach Zündung eines Lichtbogens bzw. Störlichtbogens, insbesondere parallelen Störlichtbogen, in einem elektrischen Stromkreis, insbesondere Niederspannungsstromkreis, dargestellt ist.

Auf der horizontalen X-Achse ist die Zeit t in Millisekunden (ms) dargestellt. Auf der vertikalen Y-Achse ist auf der linken Skalierung die Größe der elektrischen Spannung U in Volt (V) abgebildet. Auf der rechten Skalierung ist die Größe des elektrischen Stromes I in Ampere (A) abgebildet.

Nach Lichtbogenzündung verläuft der Strom I annähernd sinusförmig. Die Spannung U verläuft dabei "zackenförmig", mit schnellen Spannungsänderungen. Grob interpretiert ist der Spannungsverlauf in erster Näherung rechteckförmig, an Stelle eines üblicherweise sinusförmigen Verlaufs.

Abweichend von einem reinen sinusförmigen Spannungsverlauf, stellt sich in Stromkreisen bzw. Netzen, in denen ein Störlichtbogen brennt, ein stark verzerrter Spannungsverlauf ein. Abstrahiert betrachtet, lässt sich im Spannungsverlauf eine Rechteckform erkennen, die auf dem Plateau einen hoch stochastischen Anteil aufzeigt. Die Rechteckform ist dadurch gekennzeichnet, dass es bei der Lichtbogenzündung und in den nachfolgenden Spannungsnulldurchgängen der Wechselspannung zu signifikant erhöhten Spannungsänderungen kommt, die folgend als Spannungssprung bezeichnet werden, da der Anstieg der Spannungsänderung im Vergleich zu einem sinusförmigen Spannungsverlauf wesentlich größer ist.

Erfindungsgemäß sollen derartige Spannungsänderungen bzw. Spannungssprünge erkannt werden. Erfindungsgemäß mit der Auswerteeinheit AE1. Daraufhin ist ein Kriterium für ein Störlichtbogenerkennungssignal gegeben. Insbesondere kann dabei ein Detektionsansatz dahingehend erfolgen, dass Spannungssprünge bei der Lichtbogenzündung und den darauffolgenden Spannungsnulldurchgängen detektiert werden. Beispielsweise kann hierzu eine Differenzberechnung erfolgen.

Fortlaufend bzw. periodisch Spannungswerte (un, un-1) ermittelt werden, wobei die Meßfrequenz bzw. Abtastfrequenz der ermittelten Spannungswerte (un, un-1) ein Vielfaches der Frequenz der Wechselspannung betragen sollte, beispielsweise im Bereich 1 bis 200 kHz, spezifischer bei 10 bis 40 oder 60 kHz, insbesondere im Bereich 40 bis 50 kHz liegen sollte.

Mit den ermittelten Spannungswerten (un, un-1) wird dann beispielsweise eine Differenzberechnung durchgeführt, wobei ein Differenzenquotient (Dqun) für jeden Abtastwert der Spannung (un) berechnet wird. Dazu wird die Differenz des aktuellen Spannungsabtastwertes (un) zum vorhergehenden Spannungsabtastwert (un-1) gebildet. Diese Differenz (dun) durch die zeitliche Differenz (dtn), d.h. dtn = tn - tn-1, der Spannungsabtastwerte (un, un-1) dividiert, um so den Differenzenquotienten (Dqun) gemäß Formel 1 zu erhalten.

$$\mathrm{Dqun} \quad = \frac{u_n - u_{n-1}}{t_n - t_{n-1}} \ = \ \frac{dun}{dtn} \tag{1}$$

Dieser Differenzenquotient (Dqun) wird als Maß für die Änderung der Spannung nach der Zeit mit einem Schwellwert (SW) verglichen. Bei Erfüllung der Schwellwertbedingung ist ein Kriterium für ein Störlichtbogenerkennungssignal erfüllt. Alternativ zur Formel 1 kann auch vom vorhergehenden Spannungsabtastwert (un-1) der aktuelle Spannungsabtast (un) abgezogen werden (dun = (un-1) - (un)). Dadurch ändert sich lediglich das Vorzeichen des Differenzenquotienten. Bei einem Vergleich, beim dem nicht Beträge mit dem Schwellwert verglichen werden, sondern die Absolutwerte, ist dementsprechend auch das Vorzeichen des Schwellwertes zu beachten und anzupassen.

Beispielsweise wurden die Spannungswerte 30 Volt (un-1) und 50 Volt (un) mit dem zeitlichen Abstand von 20 ps, was einer Abtastfrequenz von 50 KHz entspricht, gemessen.

$$\mathrm{Dqun} \quad = \frac{50\,\text{Volt} - 30\,\text{Volt}}{20\,\mu s} \ = \ 1\,\frac{\text{V}}{\mu s}$$

Der erste Schwellwert könnte beispielsweise bei 0,5 V/ps liegen.

Der ermittelte Differenzenquotient 1 V/ps liegt über den 0,5 V/$\mu$s. Somit wird ein Störlichtbogenerkennungssignal abgegeben.

Bei einer ansteigenden Flanke im elektrischen Stromkreis ist dieser Differenzenquotient (Dqun) gemäß Formel 1 positiv. Überschreitet dieser Wert den ersten Schwellwert SW1, ist ein Kriterium für ein Störlichtbogenerkennungssignal erfüllt.

Bei einer fallenden Flanke ist dieser Differenzenquotient (Dqun) negativ. Unterschreitet dieser Wert den zweiten Schwellwert SW2, ist ein Kriterium für ein Störlichtbogenerkennungssignal erfüllt.

Der erste und zweite Schwellwert SW1, SW2 können den gleichen Betrag aufweisen und sich lediglich im Vorzeichen unterscheiden.

Alternativ kann auch der Betrag des Differenzenquotienten (Dqun) verwendet werden. Überschreitet dieser Wert den ersten Schwellwert SW1, ist ein Kriterium für ein Störlichtbogenerkennungssignal erfüllt. Somit werden sowohl bei steigenden als auch fallenden Flanken die Störlichtbogkriterien erkannt.

Im Gegensatz zum Spannungsverlauf weist der Stromverlauf von einem Störlichtbogen einen nahezu sinusförmigen Verlauf auf. Zum Zeitpunkt der Lichtbogenzündung kommt es jedoch zu einer Reduzierung des Stromanstiegs, die sich mit der physikalischen, strombegrenzenden Wirkung von Lichtbögen begründen lässt. Zusätzlich tritt eine signifikante Anstiegsänderung im Stromverlauf in jedem weiteren Stromnulldurchgang nach einer Lichtbogenzündung auf. Diese signifikante Eigenschaft im Stromverlauf soll durch eine erfindungsgemäße Auswerteeinheit AE2 erfasst werden.

Die Erkennung der Änderung bzw. Reduzierung des Stromanstieges kann beispielsweise mit einer erfindungsgemäßen Berechnung erfolgen. Hierzu werden periodisch Stromwerte (in, in-1) gemessenen bzw. abgetastet. Die Abtastung bzw. Messung muss mit einem Vielfachen der Frequenz des verwendeten Wechselstromes erfolgen. Beispielsweise mit Frequenzen im Bereich von 1 bis 100 kHz, spezifischer im Bereich 40-50 kHz.

Die Änderung des Stromanstieges kann über die Berechnung des stromseitigen zweiten Differenzenquotienten dqin erfolgen:

$$\mathrm{dqin} \quad = \frac{i_n - i_{n-1}}{t_n - t_{n-1}} \ = \ \frac{din}{dtn} \tag{2}$$

Hierbei wird auf zwei zeitlich aufeinanderfolgenden Stromwerten (in, in-1) fortlaufende eine Stromdifferenz din berechnet. Die Stromdifferenz din wird durch die zeitliche Differenz dtn (= tn - tn-1) der Stromwerte dividiert. Daraus resultierend der zweite Differenzenquotient dqin.

Aus zwei aufeinanderfolgenden Berechnungsergebnissen des Differenzenquotienten dqin und dqin-1 wird fortlaufende die Differenz berechnet, so dass der die Differenz des Differenzenquotienten Ddqin erhalten wird.

$$\mathrm{Ddqin} \quad = \mathrm{dqin} \quad - \ (\mathrm{dqin} - 1) \tag{3}$$

Über einen Schwellwertvergleich lässt sich mit Auswertung der Differenz des Differenzenquotienten Ddqin die Erfüllung eines Kriteriums für ein Störlichtbogenerkennungssignal SLES prüfen.

Alternativ zur Formel 2 kann auch der vorhergehende Stromwert (in-1) vom aktuellen Stromwert (in) abgezogen werden.

Ebenso kann alternativ zur Formel 3 vom vorhergehenden Differenzenquotienten (dqin-1) der aktuelle Differenzenquotient (dqin) abgezogen werden. Hierbei ändert sich lediglich das Vorzeichen des entstehenden Differenzenquotienten bzw. der Differenz.

Wird nicht der Betrag sondern der Absolutwert der Differenz mit einem Schwellwert verglichen, ist auf gegebenenfalls auf das richtige Vorzeichen des Schwellwertes zu achten und dieses anzupassen.

Wird an Stelle von Stromwerten die Änderung des Stromes nach der Zeit ermittelt, beispielsweise mit einer Rogowskispule, können diese Werte direkt als Differenzenquotient verwendet werden, so dass die Differenz direkt berechnet werden kann.

Beispielsweise wurde ein erster Stromwert mit 5011 A, ein nachfolgender zweiter Stromwert mit 5058 A, ein nachfolgender dritter Stromwert mit 5105 A und ein nachfolgender vierter Stromwert mit 5120 A gemessen, jeweils mit 20ps Abstand, was einer Abtastfrequenz von 50 kHz entspricht. D.h. es liegt eine ansteigende Flanke des elektrischen Stromes vor.

Daraus ergeben sich folgende Differenzenquotienten:

$$\mathrm{dqin} - 2 \quad = \frac{5058\,\mathrm{A} - 5011\,\mathrm{A}}{20\,\mathrm{\mu s}} \ = \ \frac{47\,\mathrm{A}}{20\,\mathrm{\mu s}} \ = \ 2,35 \ \mathrm{A/\mu s}$$

$$\mathrm{dqin} - 1 \quad = \frac{5105\,\mathrm{A} - 5058\,\mathrm{A}}{20\,\mathrm{\mu s}} \ = \ \frac{47\,\mathrm{A}}{20\,\mathrm{\mu s}} \ = \ 2,35 \ \mathrm{A/\mu s}$$

$$\mathrm{dqin} \quad = \frac{5120\,\mathrm{A} - 5105\,\mathrm{A}}{20\,\mathrm{\mu s}} \ = \ \frac{15\,\mathrm{A}}{20\,\mathrm{\mu s}} \ = \ 0,75 \ \mathrm{A/\mu s}$$

Daraus ergibt sich Differenz der Differenzenquotienten von:

$$\mathrm{Ddqin} - 1 = 2,35\,\frac{\mathrm{A}}{\mathrm{\mu s}} - 2,35\,\frac{\mathrm{A}}{\mathrm{\mu s}} = 0\,\frac{\mathrm{A}}{\mathrm{\mu s}}$$

$$Ddqin = 0{,}75\frac{A}{\mu s} - 2{,}35\frac{A}{\mu s} = -1{,}6\frac{A}{\mu s}$$

Der vierte Schwellwert SW4 kann beispielsweise bei -0,25 A/µs liegen. Der dritte Schwellwert SW3 kann beispielsweise den gleichen positiven Betrag aufweisen. Da die letzte Differenz des Differenzenquotienten (Ddqin) den vierten Schwellwert SW4 unterschreitet, ist ein Kriterium für ein Störlichtbogenerkennungssignal erfüllt.

D.h. durch den vierten Stromwert, bei dem eine signifikante Minderung des elektrischen Stromes eintritt, erfolgt die Erfüllung eines Kriteriums für ein Störlichtbogenerkennungssignal.

Bei einer fallenden Flanke im elektrischen Stromkreis ist diese Differenz gemäß der Formel üblicherweise positiv. Überschreitet dieser Wert den dritten Schwellwert SW3, ist ein Kriterium für ein Störlichtbogenerkennungssignal erfüllt. Bei einer steigenden Flanke ist diese Differenz üblicherweise negativ. Unterschreitet dieser Wert den vierten Schwellwert SW4, ist ein Kriterium für ein Störlichtbogenerkennungssignal erfüllt.

Der dritte und vierte Schwellwert SW3, SW4 können den gleichen Betrag aufweisen und sich lediglich im Vorzeichen unterscheiden.

Alternativ kann auch der Betrag der Differenz verwendet werden. Überschreitet dieser Wert den dritten Schwellwert SW3, ist ein Kriterium für ein Störlichtbogenerkennungssignal erfüllt. Somit werden sowohl bei fallenden als auch bei steigenden Flanken des elektrischen Stromes, insbesondere bei - idealerweise - sinusförmigen Wechselstrom, Störlichtbogenkriterien erkannt. Bei Sinus liegt üblicherweise eine fallende Flanke im Bereich 90° bis 270° vor, eine steigende Flanke im Bereich 0° bis 90° und 270° bis 360°.

Ein Entscheidungsdiagramm einer Störlichtbogenerkennung, die nicht der vorliegenden Erfindung entspricht, ist in Figur 2 dargestellt. Im Beispiel gemäß Figur 2, bei Erfüllung einer Schwellwertbedingung der Spannung und einer Schwellwertbedingung des Stromes erfolgt die Abgabe eines Störlichtbogenerkennungssignals. Insbesondere ein zeitnahes bzw. annähernd zeitgleiches Auftreten der zwei Bedingungen soll zur Abgabe eines Störlichtbogenerkennungssignals führen. Mit annähernd zeitgleichem Auftreten der zwei Bedingungen ist ein Auftreten innerhalb einer vollständigen Sinusschwingung des Wechselstromes gemeint.

Gemäß Figur 2 erfolgen in einem ersten Schritt (1) die fortlaufende Berechnung des ersten Differenzenquotienten der Spannung Dqun und die fortlaufende Berechnung der Differenz des zweiten Differenzenquotienten des Stromes Ddqin.

In einem zweiten Schritt (2) werden diese mit jeweils dem entsprechenden Schwellwert verglichen.

Erfolgt eine betragsmäßige Überschreitung der Schwellwertes für Spannung und Strom, wird in einem dritten Schritt (3) die Erkennung eines Störlichtbogens angezeigt und/oder ein Störlichtbogenerkennungssignals abgegeben.

Ist einer der beiden Schwellwerte für Spannung und Strom betragsmäßig nicht überschritten, kann in einem vierten Schritt (4) die Meldung, dass kein Störlichtbogen vorhanden ist, erfolgen.

Die Berechnung kann fortlaufend durchgeführt werden. Beispielsweise, wenn vorzeichenbehaftete Änderungsgrößen der Spannung berechnet werden, kann der Vergleich bei positiven Werten hinsichtlich der Überschreitung eines ersten, beispielsweise positiven, Schwellwertes (SW1) erfolgen oder/und bei negativen Werten hinsichtlich der Unterschreitung eines zweiten, beispielsweise negativen, Schwellwertes (SW2) erfolgen. D.h. wenn der Betrag der negativen Abweichung zahlenmäßig größer als der Betrag des negativen Schwellwertes ist.

Alternativ kann auch ein Betrag (positiv) der Änderung der Spannung gebildet werden, der dann mit dem positiven ersten Schwellwert (SW1) verglichen wird und bei dessen Überschreitung ein Kriterium für Störlichtbogenerkennungssignal erfüllt ist.

Beispielsweise, wenn vorzeichenbehaftete Änderungsgrößen des Stromes berechnet werden, kann der Vergleich bei positiven Werten hinsichtlich der Überschreitung eines dritten, beispielsweise positiven, Schwellwertes (SW3) erfolgen oder/und bei negativen Werten hinsichtlich der Unterschreitung eines vierten, beispielsweise negativen, Schwellwertes (SW4) erfolgen. D.h. wenn der Betrag der negativen Abweichung zahlenmäßig größer als der Betrag des negativen Schwellwertes ist.

Alternativ kann auch ein Betrag (positiv) der Änderung des Stromanstieges gebildet werden, der dann mit dem positiven dritten Schwellwert (SW3) verglichen wird und bei dessen Überschreitung ein Kriterium für Störlichtbogenerkennungssignal erfüllt ist.

Alternativ oder zusätzlich zum Störlichtbogenerkennungssignal kann auch eine Anzeige zwischen "Kein brennender Störlichtbogen" und "brennender Störlichtbogen" erfolgen bzw. eine dementsprechende Unterscheidung in der Anlage getroffen werden.

Erfindungsgemäß wird die Störlichtbogenerkennung mit einem weiteren Kriterium kombiniert, nämlich mit einem Vergleich der Höhe des elektrischen Stromes des Stromkreises. Der gemessene Strom, insbesondere der Effektivwert des gemessenen Stromes, der beispielsweise nach der Methode von Mann-Morrison berechnet werden kann, wird dabei mit einem fünften Schwellwert SW5 verglichen und nur wenn auch dieser fünfte Schwellwert SW5 überschritten ist und dieses Kriterium für ein Störlichtbogenerkennungssignal erfüllt sind, wird auch ein solches abgegeben. Diese als Überstromfreigabe bezeichnetes Kriterium führt zu einer sicheren Fehlerabgrenzung. Für die Störlichtbogenerkennung muss ein minimaler Störlichtbogenstrom im Stromkreis fließen, um eine Störlichtbogenerkennungssignal zu bewirken. Als Schwellwert für die Überstromfreigabe kann ein vom Betriebsstrom abhängiger Wert gewählt werden. Alternativ könnte die Schwellwertfestlegung auch lichtbogenspezifisch erfolgen, da für einen brennenden parallelen Niederspannungslichtbogen ein Lichtbogenstrom von üblicherweise 1000 A notwendig ist. Ein serieller Lichtbogen ist bei wesentlich geringeren Strömen möglich. D.h. der dritte Schwellwert SW3 kann je nach Einsatz bzw. Anwendung jeden Wert ab 1 A, 10 A, 100 A, 1000 A oder 5000 A aufweisen.

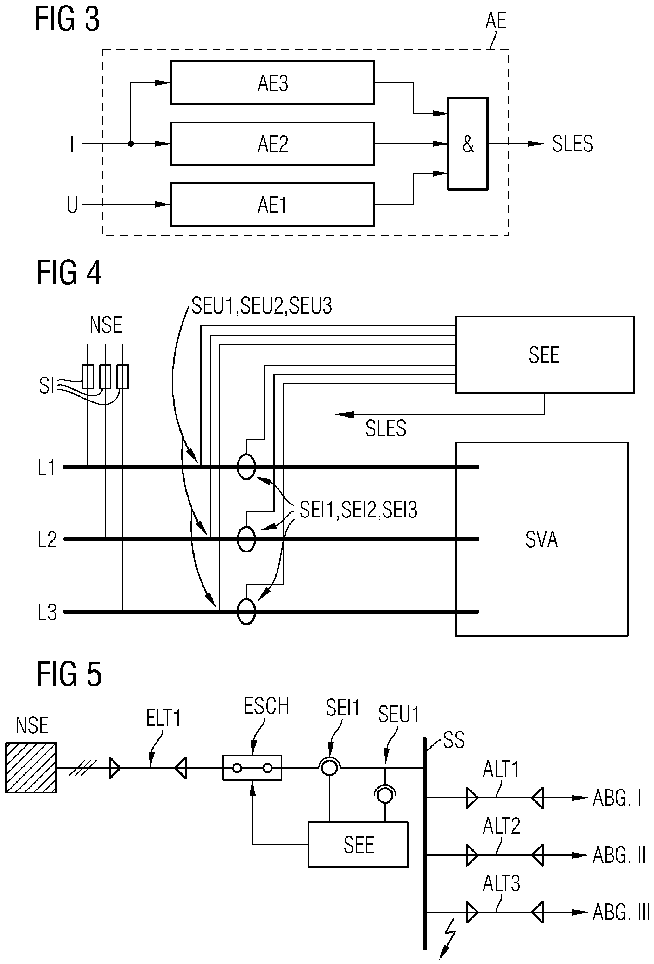

Die erfindungsgemäße Verknüpfung zwischen Überstromfreigabe und den weiteren zwei Kriterien in einer Störlichtbogenerkennungseinheit ist in Figur 3 gezeigt.

Figur 3 zeigt eine Darstellung, bei der die ermittelte Spannung U des Stromkreises einer ersten Auswerteeinheit AE1, zur Ermittlung der Spannungskriterien, zugeführt wird.

Der ermittelte Strom I des Stromkreises wird einer zweiten Auswerteeinheit AE2, zur Ermittlung der Stromkriterien, und alternativ einer dritten Auswerteeinheit AE3, zur Ermittlung einer Strombedingung, wie der Überschreitung des fünften Stromgrenzwertes SW5, zugeführt.

Die Ausgänge der der Auswerteeinheiten AE1, AE2, AE3 sind mit einer UND-Einheit & verknüpft, dessen Ausgang bei Erfüllung der Kriterien ein Störlichtbogenerkennungssignal SLES abgibt. Die drei Auswerteeinheiten können dabei als Teileinheiten bzw. Untereinheiten in einer Auswerteeinheit AE angeordnet sein.

Des Weiteren kann die Abgabe eines Störlichtbogenerkennungssignals erst dann erfolgen, wenn mindestens zweimal ein Spannungs- oder/und Stromkriterium erfüllt ist. Z.B. (die Differenz des) Differenzenquotienten einen Schwellwert überschreitet. Analog kann auch eine dreimalige, viermalige, fünfmalige, usw. Überschreitung des Schwellwertes erst zur Erfüllung eines Kriteriums führen. So wird eine besonders sichere Auswertung und Erkennung eines Störlichtbogens erreicht. Analog kann beispielsweise explizit nach einem Nulldurchgang die Auswertung durchgeführt werden. D.h. nach jedem Nulldurchgang wird die erfindungsgemäße Prüfung auf die Änderung der Spannung und des Stromes durchgeführt und erst nach zwei, drei oder mehr Abweichungen gelten die Kriterien für die Abgabe eines Störlichtbogenerkennungssignals für gegeben.

Figur 4 zeigt eine schematische Darstellung eines Übersichtsschaltbildes für eine Anlagenkonfiguration mit abgangsselektiver Störlichtbogenerkennungseinheit für die Erfassung von Störlichtbogen. Figur 4 zeigt eine Niederspannungs-Einspeisung NSE, mit Sicherungen SI, denen Stromschienen bzw. Sammelschienen L1, L2, L3 für die Leiter eines Dreiphasen-Wechselstromnetzes bzw. Stromkreises folgen. Der Neutralleiter bzw. Nullleiter ist nicht dargestellt. Jeder der drei Stromschienen L1, L2, L3 ist jeweils ein Spannungssensor SEU1, SEU2, SEU3 und ein Stromsensor SEI1, SEI2, SEI3 zugeordnet. Die Stromschienen sind mit einer Schalt- oder/und Verteilanlage SVA verbunden.

Die Spannungs- und Stromsensoren sind mit einer erfindungsgemäßen Störlichtbogenerkennungseinheit SEE verbunden, die eine erfindungsgemäße Auswerteeinheit AE aufweist. Diese weist einen Ausgang zur Abgabe eines Störlichtbogenerkennungssignals SLES auf.

Die Spannungs- und Stromsensoren ermitteln Spannungs- (un, un-1) und Stromwerte (in, in-1) der Sammelschienen L1, L2, L3 und führen sie der erfindungsgemäßen Störlichtbogenerkennungseinheit SEE zu.

Die Sensoren sind dabei außerhalb Störlichtbogenerkennungseinheit angeordnet und mit dieser verbunden.

Figur 5 zeigt eine weitere schematische Darstellung eines Übersichtsschaltbildes für eine Anlagenkonfiguration mit zentraler Störlichtbogenerkennungseinheit für die Erfassung von Störlichtbogen. Figur 5 zeigt eine Niederspannungseinspeisung NSE, der ein Einspeise-Kabel ELT1 folgt, dem ein Einspeise-Schalter ESCH folgt, dem ein Stromsensor SEI1 und ein Spannungssensor SEU1 folgt, dem eine Sammelschien SS folgt. An der Sammelschiene SS sind 3 Abgänge ABG I ABG II und ABG III vorgesehen. Diesen ist je ein Abgangs-Kabel ALT1, ALT2, ALT3 zugeordnet.

Die Sensoren SEI1, SEU1 sind mit einer Störlichtbogenerkennungseinheit SEE verbunden, dessen Ausgang wiederum mit dem Einspeise-Schalter ESCH verbunden ist. Der Einspeise-Schalter kann dabei ein Leistungsschalter sein. Bei Erkennung eines Störlichtbogens kann der elektrische Stromkreis, d.h. die Stromversorgung der Sammelschiene SS unterbrochen werden, wenn beispielsweise in einem der Abgänge ein Störlichtbogen auftritt.

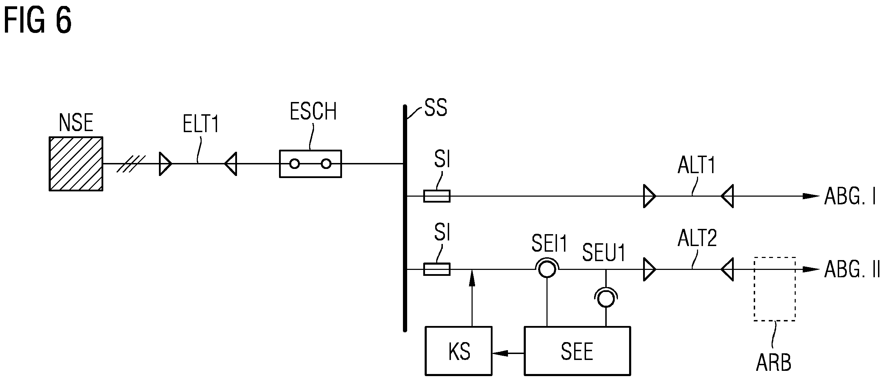

Figur 6 zeigt eine Darstellung gemäß Figur 5, mit dem Unterschied, dass die Sensoren im zweiten Abgang ABG II angeordnet sind, der zudem Sicherungen SI und einen Kurzschließer KS aufweist. Die Sensoren SEI1 und SEU1 erfassen Strom- und Spannungswerte des Abganges ABG II und geben diese an die Störlichtbogenerkennungseinheit SEE weiter. Erkennt die Störlichtbogenerkennungseinheit SEE einen Störlichtbogen, wird an ihrem Ausgang ein Störlichtbogenerkennungssignal abgegeben und zum Kurzschließer KS übertragen. Dieser schließt daraufhin den Abgang ABG II kurz, um den Störlichtbogen zu löschen.

Die Störlichtbogenerkennung gemäß Figur 5 oder 6 kann beispielsweise als mobiles System ausgeführt sein.

Die Erfindung soll im Folgenden nochmals erläutert werden.

Mit der Erfindung können Störlichtbögen, insbesondere parallele oder stromstarke, insbesondere in Niederspannungsschalt- und Verteilungsanlagen, erkannt werden. Erfindungsgemäß steht dazu insbesondere eine nummerische Lösung bzw. Detektionsalgorithmus auf Grundlage der Auswertung von gemessenen Spannungs- und Stromwerten bzw. -signalen zur Verfügung. Für die Erkennung von Störlichtbögen wird die Spannung und der Strom gemessen und Mithilfe einer jeweiligen Signalverlaufsanalyse ausgewertet. Aufgrund der in der Praxis notwendigen schnellen Lichtbogendetektion kann hierbei erfindungsgemäß eine außerordentlich schnelle zeitliche Auswertung zur Verfügung gestellt werden.

Mit dieser Erfindung können beispielsweise auf Basis einer zentralen Spannungs- und Strommessung an der Einspeisung stromstarke Störlichtbögen, beispielsweise in Schalt- und Verteileranlagen, z.B. in der Niederspannung, schnell detektiert werden.

Die Erfindung kann insbesondere vorteilhaft in bzw. im Zusammenwirken mit Leistungsschaltern oder Kurzschließern eingesetzt werden.

Eine aufwendige Installation von Lichtwellenleitern in Anlagen zur Störlichtbogenerkennung ist nicht erforderlich. Die Strommessung kann zentral realisiert und ggf. synergetisch von weiteren Betriebsmitteln genutzt werden.

Im Weiteren ist eine Implementierung in vorhandene Schalt- und Verteileranalgen einfach möglich, da ein erfindungsgemäßes Detektionssystem beispielsweise lediglich zentral eingebaut werden kann und keine Installation in einzelnen, zu schützenden Zellen erforderlich ist.

Die Erfindung kann als Baugruppe mit zentraler Strommessung realisiert sein.

Die bisher am Markt etablierten Detektionssysteme basieren auf einer optischen Fehlererkennung und weisen somit Potential zu einer Fehlauslösung durch die Einwirkung von Fremdlicht (z.B. Blitzlicht) auf. Bei der erfindungsgemäßen Lösung auf Grundlage einer Spannungs- und Strommessung ist dieses Gefahrenpotential nicht vorhanden.

Obwohl die Erfindung im Detail durch das Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Störlichtbogenerkennungseinheit für einen elektrischen Niederspannungswechselstromkreis, aufweisend

   mindestens einen Spannungssensor, zur periodischen Ermittlung von elektrischen Spannungswerten ($u_n$, $u_{n-1}$) des elektrischen Stromkreises,
   mindestens einen Stromsensor, zur periodischen Ermittlung von Stromgrößen des elektrischen Stromkreises, die mit einer Auswerteeinheit verbunden sind, die derart ausgestaltet ist,
   dass als erstes Kriterium
   bei Überschreitung eines ersten Schwellwertes (SW1) oder Unterschreitung eines zweiten Schwellwertes (SW2) der Änderung der Spannung nach der Zeit,
   als zweites Kriterium
   bei einer Differenz des Stromanstieges als Mass für die Änderung des Stromansteigens, die einen dritten Schwellwert (SW3) überschreitet oder einen vierten Schwellwert (SW4) unterschreitet,
   als drittes Kriterium der Stromwert einen fünften Schwellwert (SW5) überschreiten muss, wobei die Auswerteeinheit weiter derart ausgestaltet ist, ein Störlichtbogenerkennungssignal abzugeben nur wenn mindestens alle drei Kriterien erfüllt sind.

2. Störlichtbogenerkennungseinheit nach Patentanspruch 1,
   **dadurch gekennzeichnet,**
   **dass** zur Abgabe eines Störlichtbogenerkennungssignals auch ein optisches oder akustisches Signal vorliegen muss.

3. Störlichtbogenerkennungseinheit nach Patentanspruch 1 oder 2,
   **dadurch gekennzeichnet,**
   **dass** fortlaufend aus zwei zeitlich aufeinanderfolgenden Spannungswerten ($u_n$, $u_{n-1}$) eine Spannungsdifferenz ($du_n$) ermittelt wird, die Spannungsdifferenz ($du_n$) durch die zeitliche Differenz ($dt_n$) der Spannungswerte ($u_n$, $u_{n-1}$) dividiert wird, der daraus ermittelte erste Differenzenquotient ($Dqu_n$) als Maß für die Änderung der Spannung nach der Zeit mit dem ersten Schwellwert (SW1) verglichen wird.

4. Störlichtbogenerkennungseinheit nach Patentanspruch 1 oder 2,
   **dadurch gekennzeichnet,**
   **dass** fortlaufend aus zwei zeitlich aufeinanderfolgenden Spannungswerten ($u_n$, $u_{n-1}$) eine Spannungsdifferenz ($du_n$) ermittelt wird, die Spannungsdifferenz ($du_n$) durch die zeitliche Differenz ($dt_n$) der Spannungswerte ($u_n$, $u_{n-1}$) dividiert wird, der daraus ermittelte erste Differenzenquotient ($Dqu_n$) als Maß für die Änderung der Spannung nach der Zeit mit dem zweiten Schwellwert (SW2) verglichen wird.

**5.** Störlichtbogenerkennungseinheit nach Patentanspruch 1 oder 2,
**dadurch gekennzeichnet,**
**dass** fortlaufend aus zwei zeitlich aufeinanderfolgenden Spannungswerten (un, un-1) eine Spannungsdifferenz (dun) ermittelt wird, die Spannungsdifferenz (dun) durch die zeitliche Differenz (dtn) der Spannungswerte (un, un-1) dividiert wird, der Betrag des daraus ermittelten ersten Differenzenquotienten (Dqun) als Maß für die Änderung der Spannung nach der Zeit mit dem ersten Schwellwert (SW1) verglichen wird.

**6.** Störlichtbogenerkennungseinheit nach einem der Patentansprüche 1 bis 5,
**dadurch gekennzeichnet,**
**dass** als elektrische Stromgröße entweder ein elektrischer Stromwert (in) oder/und ein Wert für die Änderung des elektrischen Stromes nach der Zeit (i'n), respektive ein zweiter Differenzenquotient (dqin), ermittelt wird, dass im Falle der alleinigen Ermittlung des elektrischen Stromwertes (in) daraus ein Wert für die Änderung des elektrischen Stromes nach Zeit (i'n), respektive ein zweiter Differenzenquotient (dqin), berechnet wird.

**7.** Störlichtbogenerkennungseinheit nach Patentanspruch 6,
**dadurch gekennzeichnet,**
**dass** im Falle der Ermittlung von Stromwerten fortlaufend aus zwei zeitlich aufeinanderfolgenden Stromwerten (in, in-1) eine Stromdifferenz (din) ermittelt wird, die Stromdifferenz (din) durch die zeitliche Differenz (dtn) der Stromwerte dividiert wird, um so einen zweiten Differenzenquotienten (dqin) als Wert für die Änderung des elektrischen Stromes nach der Zeit zu ermitteln.

**8.** Störlichtbogenerkennungseinheit nach Patentanspruch 6 oder 7,
**dadurch gekennzeichnet,**

**dass** der zweite Differenzenquotient (dqin) vom vorhergehenden zweiten Differenzenquotienten (dqin-1) subtrahiert wird,
die so ermittelte Differenz (Ddqin) der Differenzenquotienten oder dessen Betrag als Maß für die Differenz des Stromanstieges mit dem dritten Schwellwert (SW3) verglichen wird und bei dessen Überschreitung das zweite Kriterium erfüllt ist.

**9.** Störlichtbogenerkennungseinheit nach Patentanspruch 6 oder 7,
**dadurch gekennzeichnet,**

**dass** der zweite Differenzenquotient (dqin) vom vorhergehenden zweiten Differenzenquotienten (dqin-1) subtrahiert wird,
die so ermittelte Differenz (Ddqin) der Differenzenquotienten als Maß für die Differenz des Stromanstieges mit dem vierten Schwellwert (SW4) verglichen wird
und bei dessen Unterschreitung das zweite Kriterium erfüllt ist.

**10.** Leistungsschalter für einen elektrischen Niederspannungswechselstromkreis, aufweisend eine Störlichtbogenerkennungseinheit gemäß einem der Patentansprüche 1 bis 9, der derart ausgestaltet ist, dass bei Abgabe eines Störlichtbogenerkennungssignals durch die Störlichtbogenerkennungseinheit der Leistungsschalter auslöst, um den elektrischen Stromkreis zu unterbrechen.

**11.** Kurzschließer für einen Niederspannungswechselstromkreis, aufweisend eine Störlichtbogenerkennungseinheit gemäß einem der Patentansprüche 1 bis 9, der derart ausgestaltet ist, dass bei Abgabe eines Störlichtbogenerkennungssignals durch die Störlichtbogenerkennungseinheit der Kurzschließer den elektrischen Stromkreis kurzschließt, um ein Löschen des Störlichtbogens zu bewirken.

**12.** Verfahren zur Störlichtbogenerkennung für einen elektrischen Niederspannungswechselstromkreis, bei dem periodisch elektrische Spannungs- (un, un-1) und elektrische Stromwerte (in, in-1) des Stromkreises ermittelt werden und nur dann ein Störlichtbogenerkennungssignal abgegeben wird, wenn mindestens folgende drei Kriterien erfüllt sind:

- Überschreitung eines ersten Schwellwertes (SW1) oder Unterschreitung eines zweiten Schwellwertes (SW2) der Änderung der Spannung nach der Zeit,
- Differenz des Stromanstieges als Mass für die Änderung des Stromansteigens, die einen dritten Schwellwert (SW3) überschreitet oder einen vierten Schwellwert (SW4) unterschreitet, und

- Überschreitung eines fünften Schwellwert (SW5) des Stromwertes (in, in-1).

13. Verfahren nach Patentanspruch 12, **dadurch gekennzeichnet, dass** zur Abgabe eines Störlichtbogenerkennungssignals auch ein optisches oder akustisches Signal vorliegen muss.

14. Verfahren nach Patentanspruch 12 oder 13,
    **dadurch gekennzeichnet,**
    **dass** das Störlichtbogenerkennungssignal zur Unterbrechung oder zum Kurzschluss des elektrischen Stromkreises verwendet wird.


**Claims**

1. Fault arc detection unit for an electrical low-voltage AC circuit, having

   at least one voltage sensor, for periodically ascertaining electrical voltage values (un, un-1) of the electrical circuit,
   at least one current sensor, for periodically ascertaining current variables of the electrical circuit,
   which are connected to an evaluation unit configured such that, as a first criterion,
   in the event of values above a first threshold value (SW1) or values below a second threshold value (SW2) for the change in the voltage with respect to time,
   as a second criterion,
   in the event of a difference in the current rise, as a measure of the change in the current rise, that is above a third threshold value (SW3) or below a fourth threshold value (SW4), as a third criterion, the current value has to be above a fifth threshold value (SW5), wherein the evaluation unit is further configured so as to only deliver a fault arc detection signal if at least all three criteria are met.

2. Fault arc detection unit according to Patent Claim 1,
   **characterized**
   **in that** delivery of a fault arc detection signal also requires a visual or audible signal to be present.

3. Fault arc detection unit according to Patent Claim 1 or 2,
   **characterized**
   **in that** a voltage difference (dun) is continually ascertained from two temporally successive voltage values (un, un-1), the voltage difference (dun) is divided by the difference in the voltage values (un, un-1) with respect to time (dtn), and the first difference quotient (Dqun) ascertained therefrom as a measure of the change in the voltage with respect to time is compared with the first threshold value (SW1).

4. Fault arc detection unit according to Patent Claim 1 or 2,
   **characterized**
   **in that** a voltage difference (dun) is continually ascertained from two temporally successive voltage values (un, un-1), the voltage difference (dun) is divided by the difference in the voltage values (un, un-1) with respect to time (dtn), and the first difference quotient (Dqun) ascertained therefrom is compared with the second threshold value (SW2) as a measure of the change in the voltage with respect to time.

5. Fault arc detection unit according to Patent Claim 1 or 2,
   **characterized**
   **in that** a voltage difference (dun) is continually ascertained from two temporally successive voltage values (un, un-1), the voltage difference (dun) is divided by the difference in the voltage values (un, un-1) with respect to time (dtn), and the magnitude of the first difference quotient (Dqun) ascertained therefrom is compared with the first threshold value (SW1) as a measure of the change in the voltage with respect to time.

6. Fault arc detection unit according to one of Patent Claims 1 to 5,
   **characterized**
   **in that** the electrical current variable ascertained is either an electrical current value (in) and/or a value for the change in the electrical current with respect to time (i'n), or a second difference quotient (dqin), in that if only the electrical current value (in) is ascertained then a value for the change in the electrical current with respect to time (i'n), or a second difference quotient (dqin), is calculated therefrom.

**7.** Fault arc detection unit according to Patent Claim 6,
**characterized**
**in that** if current values are ascertained then a current difference (din) is continually ascertained from two temporally successive current values (in, in-1), and the current difference (din) is divided by the difference in the current values with respect to time (dtn) in order thus to ascertain a second difference quotient (dqin) as a value for the change in the electrical current with respect to time.

**8.** Fault arc detection unit according to Patent Claim 6 or 7,
**characterized**
**in that** the second difference quotient (dqin) is subtracted from the preceding second difference quotient (dqin-1), the thus ascertained difference (Ddqin) in the difference quotients or the magnitude thereof is compared with the third threshold value (SW3) as a measure of the difference in the current rise, and the second criterion is met in the event of a value above said third threshold value.

**9.** Fault arc detection unit according to Patent Claim 6 or 7,
**characterized**
**in that** the second difference quotient (dqin) is subtracted from the preceding second difference quotient (dqin-1), the thus ascertained difference (Ddqin) in the difference quotients is compared with the fourth threshold value (SW4) as a measure of the difference in the current rise, and the second criterion is met in the event of a value below said fourth threshold value.

**10.** Circuit breaker for an electrical low-voltage AC circuit, having a fault arc detection unit according to one of Patent Claims 1 to 9, which is configured such that delivery of a fault arc detection signal by the fault arc detection unit results in the circuit breaker tripping to interrupt the electrical circuit.

**11.** Short-circuiter for a low-voltage AC circuit, having a fault arc detection unit according to one of Patent Claims 1 to 9, which is configured such that delivery of a fault arc detection signal by the fault arc detection unit results in the short-circuiter shorting the electrical circuit to cause extinguishing of the fault arc.

**12.** Method for fault-arc detection for an electrical low-voltage AC circuit,
in which electrical voltage values (un, un-1) and electrical current values (in, in-1) of the circuit are periodically ascertained, and a fault arc detection signal is only delivered if at least the following three criteria are met:

- values above a first threshold value (SW1) or below a second threshold value (SW2) for the change in the voltage with respect to time,
- a difference in the current rise, as a measure of the change in the current rise, that is above a third threshold value (SW3) or below a fourth threshold value (SW4), and
- values above a fifth threshold value (SW5) for the current value (in, in-1).

**13.** Method according to Patent Claim 12,
**characterized**
**in that** delivery of a fault arc detection signal also requires a visual or audible signal to be present.

**14.** Method according to Patent Claim 12 or 13,
**characterized**
**in that** the fault arc detection signal is used to interrupt or to short the electrical circuit.

**Revendications**

**1.** Unité de détection d'arcs électriques parasites pour un circuit de courant électrique alternatif basse tension, présentant au moins un capteur de tension, pour la détermination périodique de valeurs de tension électrique (un, un-1) du circuit de courant électrique,

au moins un capteur de courant, pour la détermination périodique de grandeurs de courant du circuit de courant électrique,
qui sont reliés à une unité d'évaluation qui est ainsi conçue qu'en tant que premier critère
en cas de dépassement d'une première valeur seuil (SW1) ou dépassement en-deça d'une deuxième valeur seuil (SW2) de la modification de la tension après le temps,

en tant que deuxième critère

en cas d'une différence de l'augmentation de courant en tant que mesure de la modification de l'augmentation du courant, qui dépasse une troisième valeur seuil (SW3) ou dépasse en-deçà une quatrième valeur seuil (SW4), en tant que troisième critère

la valeur de courant doit dépasser une cinquième valeur de courant (SW5), dans laquelle l'unité d'évaluation est en outre ainsi conçue pour émettre un signal de détection d'arc électrique parasite uniquement lorsque au moins tous les trois critères sont satisfaits.

2. Unité de détection d'arcs électriques parasites selon la revendication 1, **caractérisée en ce que** pour émettre un signal de détection d'arc électrique parasite, il doit y avoir un signal visuel ou acoustique.

3. Unité de détection d'arcs électriques parasites selon la revendication 1 ou 2, **caractérisée en ce qu'**une différence de tension (dun) est déterminée en continu à partir de deux valeurs de tension (un, un-1) consécutives dans le temps, la différence de tension (dun) est divisée par la différence temporelle (dtn) des valeurs de tension (un, un-1), le premier quotient de différence (Dqun) en tant que mesure de la modification de la tension après le temps qui en est déterminé est comparé à la première valeur seuil (SW1).

4. Unité de détection d'arcs électriques parasites selon la revendication 1 ou 2, **caractérisée en ce qu'**une différence de tension (dun) est déterminée en continu à partir de deux valeurs de tension (un, un-1) consécutives dans le temps, la différence de tension (dun) est divisée par la différence temporelle (dtn) des valeurs de tension (un, un-1), le premier quotient de différence (Dqun) en tant que mesure de la modification de la tension après le temps qui en est déterminé est comparé après le temps à la deuxième valeur seuil (SW2).

5. Unité de détection d'arcs électriques parasites selon la revendication 1 ou 2, **caractérisée en ce qu'**une différence de tension (dun) est déterminée en continu à partir de deux valeurs de tension (un, un-1) consécutives dans le temps, la différence de tension (dun) est divisée par la différence temporelle (dtn) des valeurs de tension (un, un-1), la valeur absolue du premier quotient de différence (Dqun) en tant que mesure de la modification de la tension après le temps qui en est déterminé est comparée à la première valeur seuil (SW1).

6. Unité de détection d'arcs électriques parasites selon la revendication 1 à 5, **caractérisée en ce qu'**en tant que grandeur de courant électrique, soit une valeur de courant électrique (in) et/ou une valeur de la modification du courant électrique après le temps (i'n), respectivement un deuxième quotient de différence (dqin), est déterminé(e), qu'en cas de la seule détermination de la valeur de courant électrique (in), une valeur de la modification du courant électrique après le temps (i'n) en est calculée, respectivement un deuxième quotient de différence (dqin).

7. Unité de détection d'arcs électriques parasites selon la revendication 6, **caractérisée en ce qu'**en cas de détermination en continu de valeurs de courant à partir de valeurs de courant (in, in-1) consécutives temporellement, une différence de courant (din) est déterminée, la différence de courant (din) est divisée par la différence temporelle (dtn) des valeurs de courant pour déterminer ainsi un deuxième quotient de différence (dqin) en tant que valeur de la modification du courant électrique après le temps.

8. Unité de détection d'arcs électriques parasites selon la revendication 6 ou 7, **caractérisée en ce que** le deuxième quotient de différence (dqin) est soustrait du deuxième quotient de différence (dqin-1) précédent, la différence ainsi calculée (Dqin) des quotients de différence ou sa valeur absolue en tant que mesure de la différence de l'augmentation du courant est comparée à la troisième valeur seuil (SW3) et si elle est dépassée, le deuxième critère est rempli.

9. Unité de détection d'arcs électriques parasites selon la revendication 6 ou 7, **caractérisée en ce que** le deuxième quotient de différence (dqin) est soustrait du deuxième quotient de différence (dqin-1) précédent,

la différence ainsi calculée (Dqin) des quotients de différence en tant que mesure de la différence de l'augmentation du courant est comparée à la quatrième valeur de courant (SW4)

et si elle est dépassée en-deça, le deuxième critère est satisfait.

10. Disjoncteur pour un circuit de courant électrique alternatif basse tension, présentant une unité de détection d'arcs électriques parasites selon l'une des revendications 1 à 9 ainsi conçu que lors de l'émission d'un signal de détection d'arc électrique parasite par l'unité de détection d'arcs électriques parasites, le disjoncteur se déclenche pour couper le circuit de courant électrique.

**11.** Coupe-circuit pour un circuit de courant électrique alternatif basse tension, présentant une unité de détection d'arcs électriques parasites selon l'une des revendications 1 à 9 qui ainsi conçu que lors de l'émission d'un signal de détection d'arc électrique parasite par l'unité de détection d'arcs électriques parasites, le coupe-circuit met le circuit de courant électrique en court-circuit pour supprimer l'arc électrique.

**12.** Procédé de détection d'arcs électriques parasites pour un circuit de courant électrique alternatif basse tension, dans lequel des valeurs de tension électrique (un, un-1) et des valeurs de courant électrique (in, in-1) du circuit de courant sont déterminées périodiquement et un signal de détection d'arc électrique parasite est émis uniquement lorsqu'au moins les trois critères suivants sont remplis :

- dépassement d'une première valeur seuil (SW1) ou dépassement en-deça d'une deuxième valeur seuil (SW2) de la modification de la tension après le temps,
- différence de l'augmentation de courant en tant que mesure de la modification de l'augmentation du courant, qui dépasse une troisième valeur seuil (SW3) ou dépasse en-deçà une quatrième valeur seuil (SW4), et
- dépassement d'une cinquième valeur seuil (SW5) de la valeur de courant (in, in-1).

**13.** Procédé selon la revendication 12, **caractérisé en ce que** pour émettre un signal de détection d'arc électrique parasite, il doit y avoir un signal visuel ou acoustique.

**14.** Procédé selon la revendication 12 ou 13, **caractérisé en ce que** le signal de détection d'arc électrique parasite est employé pour l'interruption ou la mise en court-circuit du circuit de courant électrique.

FIG 1

FIG 2

## FIG 3

## FIG 4

## FIG 5

FIG 6

EP 3 446 387 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20110019444 A1
- US 6987389 B1
- EP 2426802 A2